# EUROPEAN PATENT SPECIFICATION

(11) **EP 4 502 627 B1**
(45) Date of publication and mention of the grant of the patent: **22.04.2026**
(21) Application number: 23907343.0
(22) Date of filing: 17.10.2023
(51) Int. Cl.: G01R 27/02, H01M 10/48, G01R 1/067, H01M 10/42, H01M 8/04537, G01N 27/04

(54) **ELECTRODE RESISTANCE MEASURING DEVICE**
ELEKTRODENWIDERSTANDMESSVORRICHTUNG
DISPOSITIF DE MESURE DE RÉSISTANCE D'ÉLECTRODE

(30) Priority: 20.12.2022 KR 20220178973
(43) Date of publication of application: 05.02.2025
(73) Proprietor: LG Energy Solution, Ltd., Seoul 07335 (KR)
(72) Inventor: KIM, Hyuk, Daejeon 34122 (KR); JEONG, Hyeok, Daejeon 34122 (KR); RAH, Kyun Il, Daejeon 34122 (KR)
(74) Representative: Goddar, Heinz J.
(86) International application number: PCT/KR2023/016018
(87) International publication number: WO 2024/136057

(56) References cited:
- CN-A- 110 061 270
- CN-A- 110 702 991
- JP-A- 2012 243 625
- JP-A- 2020 087 764
- KR-A- 20180 093 276
- KR-B1- 101 320 786
- KR-B1- 101 320 786
- US-A1- 2010 236 335
- US-A1- 2010 279 209
- US-A1- 2012 194 208
- US-A1- 2012 194 208

## Description

### Technical Field

The present application claims the benefit of priority based on Korean Patent Application No. 10-2022-0178973 filed on December 20, 2022.

The present disclosure relates to an electrode resistance measuring apparatus, and to an electrode resistance measuring apparatus that enables single-sheet measurement of individual electrodes with high reproducibility in measuring through-plane resistance of the electrodes.

### Background Art

Methods for measuring the resistance of electrodes or auxiliary materials prepared for secondary batteries, fuel cells, etc., are divided into an in-plane resistance measurement method and a through-plane resistance measurement method.

When driving an actual battery, the through-plane resistance of the electrode that matches the direction in which electrons flow is directly related to the performance of the battery.

In addition, through-plane resistance measurement makes it possible to identify non-uniformity in the vertical direction of the electrode coated using a wet coating method, and may be applied to quality control of batteries.

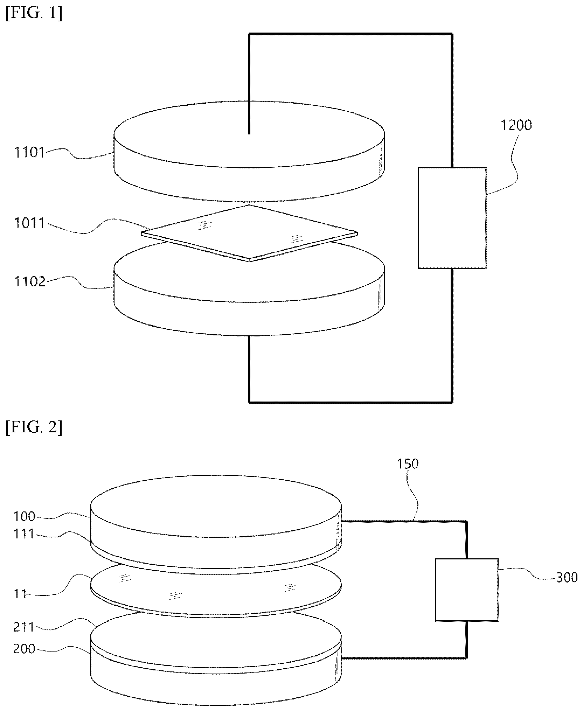

As shown in FIG. 1, existing through-plane resistance measurement may be performed by, after attaching a pair of terminals 1101 and 1102 for measuring the resistance of an electrode 1011 to both sides of the electrode 1011, respectively, applying current to both terminals 1101 and 1102 through a power supply device 1200 and measuring the resistance thereto. Contact portions of the terminals 1101 and 1102 for measuring electrode resistance may be formed as flat surfaces. At this time, due to high contact resistance between the electrode 1011 and the terminals 1101 and 1102, the reproducibility of the through-plane resistance measurement is poor.

According to a related art, in order to increase the reproducibility of the through-plane resistance measurement, there was a method of stacking several electrodes and then pressing them with high pressure. This measurement method also had difficulty in obtaining uniform values due to contact unevenness due to accumulated contact resistance and steps between multiple electrodes and between the outermost electrode and the terminal. In addition, an analysis method performed by stacking multiple electrodes had difficulty in analyzing characteristics of individual electrodes.

There is a need for a through-plane resistance measurement technology with excellent reproducibility that solves the above problems, which is capable of measurement for individual electrodes.

CN 110061270 A discloses a nondestructive measuring method for contact resistance between a bipolar plate of a fuel cell and a carbon paper interface. The method comprises the steps of S1, preparing measuring equipment, and testing carbon paper and a to-be-tested material; S2, enabling carbon paper of a first clamping unit to be in direct and full contact with carbon paper of a second clamping unit, and measuring first inter-electrode resistance R1 at the moment; S3, placing test carbon paper between the carbon paper of the first clamping unit and the carbon paper of the second clamping unit, enabling the first clamping unit and the second clamping unit to be in full contact with the two sides of the test carbon paper respectively, and measuring second inter-electrode resistance R2 at the moment; S4, replacing the test carbon paper with the to-be-tested material, enabling the first clamping unit and the second clamping unit to be in full contact with the two sides of the to-be-tested material respectively, and measuring third inter-electrode resistance R3 at the moment; and S5, calculating total contact resistance. The contact resistance between the bipolar plate of the proton exchange membrane fuel cell and the carbon paper can be measured accurately, rapidly and non-destructively.

### Disclosure of the Invention

### Technical Goals

The present disclosure relates to an electrode resistance measuring apparatus, and is to provide an electrode resistance measuring apparatus that enables single-sheet measurement of individual electrodes with high reproducibility in measuring through-plane resistance of the electrodes.

Technical objects to be achieved by the present disclosure are not limited to the technical objects mentioned above, and other technical tasks that are not mentioned will be clearly understood by those skilled in the art from the description below.

### Technical Solutions

According to an aspect of the invention, an electrode resistance measuring apparatus is defined in claim 1.

An electrode resistance measuring apparatus of the present disclosure measures the through-plane resistance of electrodes, which may enable single-sheet measurement of individual electrodes with high reproducibility.

The electrode resistance measuring apparatus of the present disclosure may minimize contact resistance between electrodes and terminals when measuring the through-plane resistance.

The electrode resistance measuring apparatus of the present disclosure may obtain resistance measurement values for individual electrodes in a state where contact resistance is minimized by forming a microporous conductive layer on a surface of the terminal in contact with the electrode, completely adhering to a rough surface of the individual electrode.

### Brief Description of Drawings

FIG. 1 is a perspective view illustrating a through-plane resistance measurement method according to a related art.
FIG. 2 is a perspective view illustrating an embodiment of an electrode resistance measuring apparatus of the present disclosure.
FIG. 3 is a cross-sectional view illustrating a state in which an upper terminal and a lower terminal are in close contact with a measurement target electrode.
FIG. 4 is a perspective view illustrating another embodiment of an electrode resistance measuring apparatus of the present disclosure.
FIG. 5 is a graph illustrating through-plane resistance measurement values according to Examples 1 and 2 and Comparative Example.

### Best Mode for Carrying Out the Invention

An electrode resistance measuring apparatus of the present disclosure includes:
an upper terminal whose bottom surface is in close contact with an upper surface of a measurement target electrode;
a lower terminal whose upper surface is in close contact with a lower surface of the measurement target electrode; and
a resistance measuring unit electrically connected to the upper terminal and the lower terminal to measure a resistance of the measurement target electrode,
wherein microporous layers are formed on the bottom surface of the upper terminal and the upper surface of the lower terminal.

In the electrode resistance measuring apparatus of the present disclosure, a material of the microporous layers may include at least one of carbon, conductive metal, and conductive polymer.

In the electrode resistance measuring apparatus of the present disclosure, the microporous layer of the upper terminal may be formed by coating or bonding fine particles with a D₅₀ of 5 µm or less or a fine fiber network with a width of 10 µm or less to a bottom surface of a conductive pressure plate made of a rigid material, the microporous layer of the lower terminal may also be formed by coating or bonding fine particles with a D₅₀ of 5 µm or less or a fine fiber network with a width of 10 µm or less to an upper surface of a conductive support plate made of a rigid material, and a material of the fine particles or the fine fiber networks coated or bonded to the upper terminal and the lower terminal may include at least one of transition metal, aluminum, carbon, and conductive polymer.

In the electrode resistance measuring apparatus of the present disclosure, the upper terminal may include a conductive pressure plate made of a conductive material and having a bottom surface formed as a plane perpendicular to a vertical direction, and a first gas diffusion layer (GDL) fixed to the bottom surface of the conductive pressure plate, and the lower terminal may include a conductive support plate made of a conductive material and having an upper surface formed as a plane perpendicular to the vertical direction, and a second GDL fixed to the upper surface of the conductive support plate, wherein conductive paste may fix the first GDL and the conductive pressure plate between them and the second GDL and the conductive support plate between them.

In the electrode resistance measuring apparatus of the present disclosure, a material of the conductive pressure plate and the conductive support plate may include at least one of transition metal on a periodic table, aluminum, and carbon.

In the electrode resistance measuring apparatus of the present disclosure, each of the first GDL and the second GDL includes the microporous layer and a carbon fiber layer.

In the electrode resistance measuring apparatus of the present disclosure, an upper surface of the carbon fiber layer of the first GDL is adhered to the bottom surface of the conductive pressure plate by the conductive paste, the microporous layer is stacked on a bottom surface of the carbon fiber layer in the first GDL, a bottom surface of the carbon fiber layer of the second GDL is adhered to the upper surface of the conductive support plate by the conductive paste, and the microporous layer is stacked on an upper surface of the carbon fiber layer in the second GDL.

In the electrode resistance measuring apparatus of the present disclosure, the conductive paste may be obtained by mixing conductive particles, binder, and solvent in a paste state, a material of the conductive particles of the conductive paste may include at least one of carbon black, graphite, CNT, graphene, transition metal, and aluminum, and a size of the conductive particles of the conductive paste may be D₅₀ of 20 µm or less.

In the electrode resistance measuring apparatus of the present disclosure, the conductive paste may be formed to a thickness of 20 µm to 200 µm between the first GDL and the conductive pressure plate and between the second GDL and the conductive support plate.

In the electrode resistance measuring apparatus of the present disclosure, a porosity of the microporous layer of the first GDL and the microporous layer of the second GDL may be 30% to 80%.

In the electrode resistance measuring apparatus of the present disclosure, a thickness of the microporous layer of the first GDL and the microporous layer of the second GDL may be 20 µm to 150 µm.

In the electrode resistance measuring apparatus of the present disclosure, a load body for pressing the measurement target electrode may be stacked on an upper surface of the upper terminal.

In the electrode resistance measuring apparatus of the present disclosure, each of the upper terminal and the load body may be provided in a disk shape.

### Modes for Carrying Out the Invention

Hereinafter, embodiments according to the present disclosure will be described in detail with reference to the attached drawings. In this process, the size or shape of the components shown in the drawings may be exaggerated for clarity and convenience of explanation. In addition, terms specifically defined in consideration of the configuration and operation of the present disclosure may vary depending on the intention or custom of the user or operator. Definitions of these terms should be made based on the content throughout this specification.

In the description of the present disclosure, it should be noted that an orientation or positional relationship indicated by the terms such as "center", "upper", "lower", "left", "right", "vertical", "horizontal", "inner side", "outer side", "one side", and "other side" is based on an orientation or positional relationship shown in a drawing or an orientation or positional relationship that is placed when using the product of the present disclosure on a daily basis, and is merely for explanation and brief description of the present disclosure, and it does not suggest or imply that the displayed device or element must necessarily be configured or operated in a specified orientation and should not be construed as limiting the present disclosure.

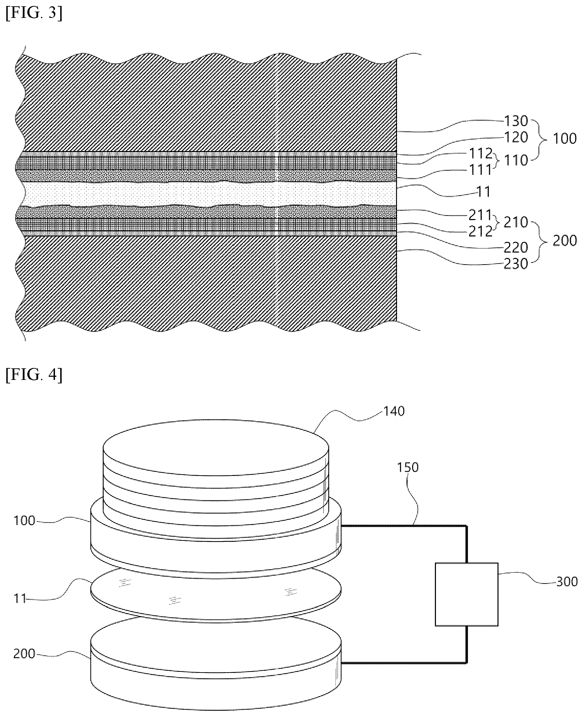

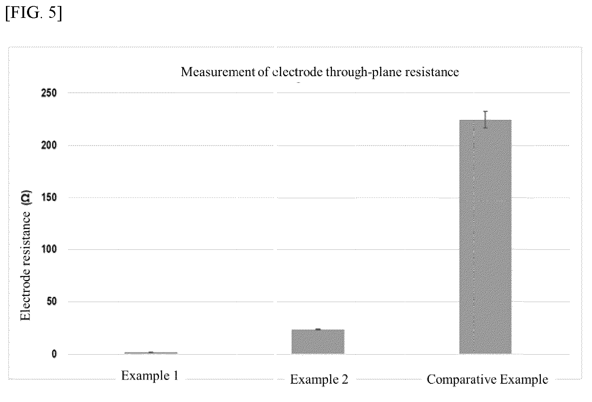

FIG. 2 is a perspective view illustrating an embodiment of an electrode resistance measuring apparatus of the present disclosure. FIG. 3 is a cross-sectional view illustrating a state in which an upper terminal 100 and a lower terminal 200 are in close contact with a measurement target electrode 11. FIG. 4 is a perspective view illustrating another embodiment of an electrode resistance measuring apparatus of the present disclosure. FIG. 5 is a graph illustrating through-plane resistance measurement values according to Examples 1 and 2 and Comparative Example.

Hereinafter, with reference to FIGS. 2 to 5, the electrode resistance measuring apparatus of the present disclosure will be described in detail. Hereinafter, in the description, a vertical direction may be the direction of gravity.

The electrode resistance measuring apparatus of the present disclosure may be capable of measuring through-plane resistance with high reproducibility for individual electrodes.

As shown in FIG. 2, the electrode resistance measuring apparatus of the present disclosure may include:
the upper terminal 100 whose bottom surface is in close contact with an upper surface of the measurement target electrode 11;
the lower terminal 200 whose upper surface is in close contact with a lower surface of the measurement target electrode 11; and
a resistance measuring unit 300 electrically connected to the upper terminal 100 and the lower terminal 200 to measure a resistance of the measurement target electrode 11,
wherein microporous layers 111 and 211 may be formed on the bottom surface of the upper terminal 100 and the upper surface of the lower terminal 200.

In the electrode resistance measuring apparatus of the present disclosure, the measurement target electrode 11 may be provided in a planar shape perpendicular to the vertical direction. Specifically, the measurement target electrode 11 may be made of a conductive material and may be provided in the shape of a plate or sheet. For example, the measurement target electrode 11 may be formed by applying electrode slurry to Cu foil or Al foil and then drying it. The electrode slurry may be obtained by mixing an active material, a conductive material, a binder, and a solvent in a paste state, or may be obtained by mixing a conductive material, a binder, and a solvent in a paste state to improve the adhesion between an electrode containing an active material and a conductive foil as a current collector. At this time, the surface on which the electrode slurry is dried may be rough depending on the situation and may not be formed as an ideal plane.

As shown in FIGS. 2 and 4, the area of the bottom surface of the upper terminal 100 or the upper surface of the lower terminal 200 may be formed to be equal to or smaller than the area of the measurement target electrode 11. In the electrode resistance measuring apparatus of the present disclosure, since the bottom surface of the upper terminal 100 and the upper surface of the lower terminal 200 are formed of the microporous layers 111 and 211 and the thickness of the measurement target electrode 11 may be formed very thin, the upper terminal 100 and the lower terminal 200 may be in direct contact when the area of the bottom surface of the upper terminal 100 and the upper surface of the lower terminal 200 are formed larger than the area of the measurement target electrode 11. Accordingly, it may be desirable for the area of the bottom surface of the upper terminal 100 or the upper surface of the lower terminal 200 to be formed equal to or smaller than the area of the measurement target electrode 11.

In the electrode resistance measuring apparatus of the present disclosure, the microporous layer (111, 211) may be formed by applying a carbon paste to a carbon fiber layer (112, 212) such as carbon paper, followed by drying and heat treatment. The carbon paste, which is formed into the microporous layer (111, 211) after the drying and heat treatment, may be obtained by mixing carbon powder, fluororesin, water, and alcohol.

The resistance measuring unit 300 of the present disclosure may include a current supplier that supplies input current between the upper terminal 100 and the lower terminal 200, and a voltmeter that measures the voltage between the upper terminal 100 and the lower terminal 200. The input current is not limited to alternating current or direct current and may vary depending on the analysis purpose. The resistance measuring unit 300 may be electrically connected to each of the upper terminal 100 and the lower terminal 200 through a conductive cable 150.

As shown in FIG. 3, in the electrode resistance measuring apparatus of the present disclosure, the upper terminal 100 may include a conductive pressure plate 130 made of a conductive material and having a bottom surface formed as a plane perpendicular to a vertical direction, and a first gas diffusion layer (GDL) 110 fixed to the bottom surface of the conductive pressure plate 130, and the lower terminal 200 may include a conductive support plate 230 made of a conductive material and having an upper surface formed as a plane perpendicular to the vertical direction, and a second GDL 210 fixed to the upper surface of the conductive support plate 230.

In addition, conductive paste 120 and 220 may fix the first GDL 110 and the conductive pressure plate 130 between them and the second GDL 210 and the conductive support plate 230 between them.

The electrode resistance measuring apparatus of the present disclosure may, by fixing the conductive pressure plate 130 and the first GDL 110, and the conductive support plate 230 and the second GDL 210, which are made of different materials, with the conductive paste 120 and 220, prevent the relative positions between each other from changing and prevent contact conditions from changing at interfaces by filling voids at the interfaces between each other with the conductive paste 120 and 220. Specifically, after applying the conductive paste 120 to the bottom surface of the conductive pressure plate 130 or the upper surface of the first GDL, the conductive pressure plate 130 and the first GDL 110 may be brought into close contact with each other and then dried to fix the conductive pressure plate 130 and the first GDL 110 to each other. Similarly, after applying the conductive paste 220 between the conductive support plate 230 and the second GDL 210, the conductive support plate 230 and the second GDL 210 may be brought into close contact with each other and then dried to fix the conductive support plate 230 and the second GDL 210 to each other.

The material of the conductive pressure plate 130 and the conductive support plate 230 may include at least one of transition metal on a periodic table, aluminum, and carbon. For example, the transition metal may be SUS, copper, titanium, nickel, etc. As another example, the conductive pressure plate 130 and the conductive support plate 230 may be made by coating the surface of a rigid material with a conductive material such as gold. In other words, the conductive pressure plate 130 and the conductive support plate 230 may be made of a rigid conductive material. The conductive pressure plate 130 and the conductive support plate 230 may be brought into close contact with the measurement target electrode 11 by pressing the conductive pressure plate downward with the measurement target electrode 11 in between, in a state where the bottom surface of the conductive pressure plate 130 and the upper surface of the conductive support plate 230 are arranged to face each other.

The first GDL 110 and the second GDL 210 may include the microporous layers 111 and 211 and the carbon fiber layers 112 and 212. As described above, the first GDL 110 and the second GDL 210 may be prepared by applying carbon paste to the carbon fiber layers 112 and 212 such as carbon paper, followed by drying and heat treatment to form the microporous layers 111 and 211. The carbon paste, which is formed into the microporous layer (111, 211) after the drying and heat treatment, may be obtained by mixing carbon powder, fluororesin, water, and alcohol. The fluororesin may be one or more selected from the group consisting of polytetrafluoroethylene (PTFE), tetrafluoroethylene-perfluoroalkyl vinyl ether copolymer (PFA), tetrafluoroethylene-hexafluoropropylene copolymer (FEP), polychlorotrifluoroethylene (PCTFE), tetrafluoroethylene-ethylene copolymer (ETFE), and polyfluorobinylidene (PVDF).

The carbon fiber layer (112, 212) may be formed of carbon fiber. The carbon fiber (CF) may be a fibrous carbon material with a mass content of carbon element of 90% or more. Specifically, carbon fiber may be a fiber that has mostly a graphite structure obtained by pyrolysis of an organic precursor (material before carbonization) fiber. In addition, the carbon fiber layer (112, 212) may be coated with fluororesin.

As shown in FIG. 3, an upper surface of the carbon fiber layer 112 of the first GDL 110 may be adhered to the bottom surface of the conductive pressure plate 130 by the conductive paste 120, the microporous layer 111 may be stacked on a bottom surface of the carbon fiber layer 112 of the first GDL 110, a bottom surface of the carbon fiber layer 212 of the second GDL 210 may be adhered to the upper surface of the conductive support plate 230 by the conductive paste 220, and the microporous layer 211 may be stacked on an upper surface of the carbon fiber layer 212 in the second GDL 210. In other words, the electrode resistance measuring apparatus of the present disclosure may, by adhering the carbon fiber layers 112 and 212 of the GDLs with the conductive paste 120 and 220 to the conductive pressure plate 130 and the conductive support plate 230, which are made of materials that are advantageous for forming a flat surface with high-quality smoothness, and bringing the microporous layers 111 and 211 of the GDLs into close contact with surfaces of the measurement target electrode 11 which have poor smoothness, improve reproducibility when measuring through-plane resistance by minimizing contact resistance.

The conductive paste (120, 220) may be obtained by mixing conductive particles, binder, and solvent in a paste state. The material of the conductive particles of the conductive paste (120, 220) may include at least one of carbon black, graphite, CNT, graphene, transition metal, and aluminum. The size of the conductive particles of the conductive paste (120, 220) may be D₅₀ of 20 µm or less.

The conductive paste (120, 220) may be formed to a thickness of 20 µm to 200 µm between the first GDL 110 and the conductive pressure plate 130 and between the second GDL 210 and the conductive support plate 230. The thickness of the conductive paste 120 and 220 may be determined considering the state of the carbon fiber layers 112 and 212 or the smoothness of the conductive pressure plate 130 and the conductive support plate 230.

The porosity of the microporous layer 111 of the first GDL 110 and the microporous layer 211 of the second GDL 210 may be 30% to 80%. More preferably, the porosity of the microporous layer 111 of the first GDL 110 and the microporous layer 211 of the second GDL 210 may be 40% to 70%. The microporous layer 111 of the first GDL 110 and the microporous layer 211 of the second GDL 210 may have a thickness of 20 µm to 150 µm.

As another embodiment, the microporous layer of the upper terminal may be formed by coating or bonding fine particles with a D₅₀ of 5 µm or less or a fine fiber network with a width of 10 µm or less to the bottom surface of the conductive pressure plate made of a rigid material. In addition, the microporous layer of the lower terminal may also be formed by coating or bonding fine particles with a D₅₀ of 5 µm or less or a fine fiber network with a width of 10 µm or less to an upper surface of a conductive support plate made of a rigid material. At this time, the material of the fine particles or the fine fiber network coated or bonded to the upper terminal and the lower terminal may include at least one of transition metal, aluminum, carbon, and conductive polymer.

As shown in FIG. 4, a load body 140 for pressing the measurement target electrode 11 may be stacked on an upper surface of the upper terminal 100. The load body 140 may be provided in plurality. In measuring through-plane resistance, the amount of pressure applied to the measurement target electrode 11 by the upper terminal 100 may affect the measurement results. Therefore, it is necessary to pressurize the measurement target electrode 11 with an appropriate level of pressure, and in the electrode resistance measuring apparatus of the present disclosure, the pressure with which the upper terminal 100 presses the measurement target electrode 11 may be adjusted by adjusting the number of load bodies 140. The pressure with which the upper terminal 100 presses the measurement target electrode 11 may preferably be 0.01 kgf/cm² to 0.2 kgf/cm². If the pressure with which the upper terminal 100 presses the measurement target electrode 11 is less than 0.01 kgf/cm², the contact resistance may increase and measurement precision may decrease, and if the pressure with which the upper terminal 100 presses the measurement target electrode 11 exceeds 0.2 kgf/cm², the thickness of the measurement target electrode 11 may change, affecting the measured value.

The upper terminal 100 and the load body 140 may be provided in a disk shape. For accurate measurement in the electrode resistance measuring apparatus of the present disclosure, it may be important that the upper terminal 100 is not tilted. Accordingly, the upper terminal 100 and the load body 140 may be provided in a disk shape so as not to have anisotropy with respect to the direction perpendicular to the vertical direction. The upper terminal 100 may be provided with an alignment means for aligning the center of the load body 140 with the center of the upper terminal 100. The alignment means may be a projection, a groove, a marker, or the like. The conductive cable 150 for electrical connection between the upper terminal 100 and the resistance measuring unit 300 may be laterally coupled to the upper terminal 100 so as not to interfere with stacking of the load body 140.

### Example 1

The cathode of the lithium secondary battery was prepared as the measurement target electrode 11 with a size of 19.6 cm².

The conductive pressure plate 130 and the conductive support plate 230 were made of SUS material, and the total weight of the upper terminal 100 and the load body 140 was prepared to be 0.3 kg. The first GDL 110 and the second GDL 210 were prepared with Sigracet 39 BC from SGL.

The conductive paste 120 and 220 was applied between the conductive pressure plate 130 and the first GDL 110 and between the conductive support plate 230 and the second GDL 210 and then dried, so that the conductive pressure plate 130 and the first GDL 110 and the conductive support plate 230 and the second GDL 210 were fixed to each other.

As the resistance measuring unit 300, Hioki BT3563 HiTESTER from Hioki Corporation was used. An alternating current of 1 kHz was applied as an input current between the upper terminal 100 and the lower terminal 200.

After the measurement target electrode 11 was completely separated from the upper terminal 100 and the lower terminal 200, the measurement was repeated three times.

### Example 2

The cathode of the lithium secondary battery was prepared as the measurement target electrode 11 with a size of 19.6 cm².

The conductive pressure plate 130 and the conductive support plate 230 were made of SUS material, and the total weight of the upper terminal 100 and the load body 140 was prepared to be 0.3 kg. The first GDL 110 and the second GDL 210 were prepared with Sigracet 39 BC from SGL.

The conductive pressure plate 130 and the first GDL 110 and the conductive support plate 230 and the second GDL 210 were directly in close contact without being fixed with conductive paste therebetween.

As the resistance measuring unit 300, Hioki BT3563 HiTESTER from Hioki Corporation was used. An alternating current of 1 kHz was applied as an input current between the upper terminal 100 and the lower terminal 200.

After the measurement target electrode 11 was completely separated from the upper terminal 100 and the lower terminal 200, the measurement was repeated three times.

### Comparative Example

The cathode of the lithium secondary battery was prepared as the measurement target electrode 11 with a size of 19.6 cm².

The conductive pressure plate 130 and the conductive support plate 230 were made of SUS material, and the total weight of the upper terminal 100 and the load body 140 was prepared to be 0.3 kg.

As shown in FIG. 1, the conductive pressure plate 130 and the measurement target electrode 11 and the conductive support plate 230 and the measurement target electrode 11 were directly in close contact without GDL insertion therebetween.

As the resistance measuring unit 300, Hioki BT3563 HiTESTER from Hioki Corporation was used. An alternating current of 1 kHz was applied as an input current between the upper terminal 100 and the lower terminal 200.

After the measurement target electrode 11 was completely separated from the upper terminal 100 and the lower terminal 200, the measurement was repeated three times.

The resistance value shown in FIG. 5 may be an average value for repeated measurements. As shown in FIG. 5, in through-plane resistance measurement, when the microporous layer 111, 211 is present on the surface of the terminal in contact with the measurement target electrode 11, it may be seen that the measured resistance value rapidly decreases. In particular, in the case of Example 1 and Comparative Example, it may be seen that the measured resistance values differ by about 50 times or more. This is because contact resistance that interferes with measurement has been minimized. In addition, as a result of calculating the precision for Examples 1 and 2 and Comparative Example, it was calculated to be 0.55%, 2.36%, and 3.55%, respectively. In other words, Examples 1 and 2 showed excellent precision compared to the Comparative Example, and in particular, Example 1 achieved excellent reproducibility with a precision of 0.55%.

The precision was calculated as a percentage of the standard deviation value relative to the average value of electrode resistance.

Although embodiments according to the present disclosure have been described above, they are merely illustrative, and those skilled in the art will understand that various modifications are possible therefrom. Therefore, the technical protection scope of the present disclosure should be determined by the appended claims.

<Explanation of Symbols> 11...Measurement target electrode, 100...Upper terminal, 110...First GDL, 111...Microporous layer, 112...Carbon fiber layer, 120...Conductive paste, 130...Conductive pressure plate, 140...Load body, 150...Conductive cable, 200...Lower terminal, 210...Second GDL, 211...Microporous layer, 212...Carbon fiber layer, 220...Conductive paste, 230...Conductive support plate, 300...Resistance measuring unit

### Industrial Applicability

An electrode resistance measuring apparatus of the present disclosure measures the through-plane resistance of electrodes, which may enable single-sheet measurement of individual electrodes with high reproducibility.

The electrode resistance measuring apparatus of the present disclosure may minimize contact resistance between the electrodes and terminals when measuring the through-plane resistance.

The electrode resistance measuring apparatus of the present disclosure may obtain resistance measurement values for individual electrodes in a state where the contact resistance is minimized by forming a microporous conductive layer on the surface of the terminal in contact with the electrode, completely adhering to the rough surface of the individual electrode.

## Claims

1. An electrode resistance measuring apparatus comprising:
an upper terminal (100) whose bottom surface is configured to be coupled to an upper surface of a measurement target electrode (11);
a lower terminal (200) whose upper surface is configured to be coupled to a lower surface of the measurement target electrode (11); and
a resistance measuring unit (300) electrically connected to the upper terminal (100) and the lower terminal to measure a resistance of the measurement target electrode (11),
wherein microporous layers (111, 211) are formed on the bottom surface of the upper terminal (100) and the upper surface of the lower terminal (200), respectively, the microporous layers (111, 211) are configured to be in direct contact with the measurement target electrode (11),
wherein the upper terminal (100) comprises:
a conductive pressure plate (130) made of a conductive material and having a bottom surface formed as a plane perpendicular to a vertical direction; and
a first gas diffusion layer (110) fixed to the bottom surface of the conductive pressure plate (130), and wherein
the lower terminal comprises:
a conductive support plate (230) made of a conductive material and having an upper surface formed as a plane perpendicular to the vertical direction; and
a second gas diffusion layer (210) fixed to the upper surface of the conductive support plate (230);
wherein each of the first gas diffusion layer (110) and the second gas diffusion layer (210) comprises the microporous layer (111, 211) and a carbon fiber layer (112, 212);
wherein an upper surface of the carbon fiber layer (112) of the first gas diffusion layer (110) is adhered to the bottom surface of the conductive pressure plate (130),
the microporous layer (111) is stacked on a bottom surface of the carbon fiber layer (112) in the first gas diffusion layer (110),
a bottom surface of the carbon fiber layer (212) of the second gas diffusion layer (210) is adhered to the upper surface of the conductive support plate (230), and
the microporous layer (211) is stacked on an upper surface of the carbon fiber layer (212) in the second gas diffusion layer (210) , and
wherein conductive paste (120, 220) fixes the upper surface of the carbon fiber layer (112) of the first gas diffusion layer (110) to the bottom surface of the conductive pressure plate (130) and the bottom surface of the carbon fiber layer (212) of the second gas diffusion layer (210) to the upper surface of the conductive support plate (230).

2. The electrode resistance measuring apparatus of claim 1, wherein a material of the microporous layers (111, 211) comprises at least one of carbon, conductive metal, and conductive polymer.

3. The electrode resistance measuring apparatus of claim 1, wherein the microporous layer (111, 211) of the upper terminal (100) is formed by coating or bonding fine particles with a D₅₀ of 5 µm or less or a fine fiber network with a width of 10 µm or less to a bottom surface of a conductive pressure plate (130) made of a rigid material,
the microporous layer (111, 211) of the lower terminal is also formed by coating or bonding fine particles with a D₅₀ of 5 µm or less or a fine fiber network with a width of 10 µm or less to an upper surface of a conductive support plate (230) made of a rigid material, and
a material of the fine particles or the fine fiber networks coated or bonded to the upper terminal (100) and the lower terminal comprises at least one of transition metal, aluminum, carbon, and conductive polymer.

4. The electrode resistance measuring apparatus of claim 1, wherein a material of the conductive pressure plate (130) and the conductive support plate (230) comprises at least one of transition metal on a periodic table, aluminum, and carbon.

5. The electrode resistance measuring apparatus of claim 1, wherein the conductive paste (120, 220) is obtained by mixing conductive particles, binder, and solvent in a paste state,
a material of the conductive particles of the conductive paste (120, 220) comprises at least one of carbon black, graphite, CNT, graphene, transition metal, and aluminum, and
a size of the conductive particles of the conductive paste (120, 220) is D₅₀ of 20 µm or less.

6. The electrode resistance measuring apparatus of claim 5, wherein the conductive paste (120, 220) is formed to a thickness of 20 µm to 200 µm between the first gas diffusion layer and the conductive pressure plate (130) and between the second gas diffusion layer and the conductive support plate (230).

7. The electrode resistance measuring apparatus of claim 1, wherein a porosity of the microporous layer (111, 211) of the first gas diffusion layer and the microporous layer (111, 211) of the second gas diffusion layer is 30% to 80%.

8. The electrode resistance measuring apparatus of claim 1, wherein a thickness of the microporous layer (111, 211) of the first gas diffusion layer and the microporous layer (111, 211) of the second gas diffusion layer is 20 µm to 150 µm.

9. The electrode resistance measuring apparatus of claim 3, wherein a load body (140) for pressing the measurement target electrode (11) is stacked on an upper surface of the upper terminal (100).

10. The electrode resistance measuring apparatus of claim 9, wherein each of the upper terminal (100) and the load body (140) is provided in a disk shape.

## Patentansprüche

1. Elektrodenwiderstandsmessvorrichtung, umfassend:
einen oberen Anschluss (100), dessen untere Oberfläche konfiguriert ist, um mit einer oberen Oberfläche einer Messzielelektrode (11) gekoppelt zu werden;
einen unteren Anschluss (200), dessen obere Oberfläche konfiguriert ist, um mit einer unteren Oberfläche der Messzielelektrode (11) gekoppelt zu werden; und
eine Widerstandsmesseinheit (300), die elektrisch mit dem oberen Anschluss (100) und dem unteren Anschluss verbunden ist, um einen Widerstand der Messzielelektrode (11) zu messen,
wobei mikroporöse Schichten (111, 211) jeweils auf der unteren Oberfläche des oberen Anschlusses (100) und der oberen Oberfläche des unteren Anschlusses (200) gebildet sind, wobei die mikroporösen Schichten (111, 211) konfiguriert sind, um in direktem Kontakt mit der Messzielelektrode (11) zu sein,
wobei der obere Anschluss (100) umfasst:
eine leitfähige Druckplatte (130), die aus einem leitfähigen Material hergestellt ist und eine untere Oberfläche aufweist, die als eine Ebene senkrecht zu einer vertikalen Richtung gebildet ist; und
eine erste Gasdiffusionsschicht (110), die an der unteren Oberfläche der leitfähigen Druckplatte (130) befestigt ist, und wobei
der untere Anschluss umfasst:
eine leitfähige Trägerplatte (230), die aus einem leitfähigen Material hergestellt ist und eine obere Oberfläche aufweist, die als eine Ebene senkrecht zu der vertikalen Richtung gebildet ist; und
eine zweite Gasdiffusionsschicht (210), die an der oberen Oberfläche der leitfähigen Trägerplatte (230) befestigt ist;
wobei jede der ersten Gasdiffusionsschicht (110) und der zweiten Gasdiffusionsschicht (210) die mikroporöse Schicht (111, 211) und eine Kohlenstofffaserschicht (112, 212) umfasst;
wobei eine obere Oberfläche der Kohlenstofffaserschicht (112) der ersten Gasdiffusionsschicht (110) an der unteren Oberfläche der leitfähigen Druckplatte (130) haftet,
die mikroporöse Schicht (111) auf einer unteren Oberfläche der Kohlenstofffaserschicht (112) in der ersten Gasdiffusionsschicht (110) gestapelt ist,
eine untere Oberfläche der Kohlenstofffaserschicht (212) der zweiten Gasdiffusionsschicht (210) an der oberen Oberfläche der leitfähigen Trägerplatte (230) haftet, und
die mikroporöse Schicht (211) auf einer oberen Oberfläche der Kohlenstofffaserschicht (212) in der zweiten Gasdiffusionsschicht (210) gestapelt ist,
und
wobei leitfähige Paste (120, 220) die obere Oberfläche der Kohlenstofffaserschicht (112) der ersten Gasdiffusionsschicht (110) an der unteren Oberfläche der leitfähigen Druckplatte (130) und die untere Oberfläche der Kohlenstofffaserschicht (212) der zweiten Gasdiffusionsschicht (210) an der oberen Oberfläche der leitfähigen Trägerplatte (230) befestigt.

2. Elektrodenwiderstandsmessvorrichtung nach Anspruch 1, wobei ein Material der mikroporösen Schichten (111, 211) mindestens eines von Kohlenstoff, leitfähigem Metall und leitfähigem Polymer umfasst.

3. Elektrodenwiderstandsmessvorrichtung nach Anspruch 1, wobei die mikroporöse Schicht (111, 211) des oberen Anschlusses (100) durch Beschichten oder Binden feiner Partikel mit einem D₅₀ von 5 µm oder weniger oder eines Feinfasernetzwerks mit einer Breite von 10 µm oder weniger an eine untere Oberfläche einer leitfähigen Druckplatte (130), die aus einem starren Material hergestellt ist, gebildet ist,
die mikroporöse Schicht (111, 211) des unteren Anschlusses auch durch Beschichten oder Binden feiner Partikel mit einem D₅₀ von 5 µ m oder weniger oder eines Feinfasernetzwerks mit einer Breite von 10 µm oder weniger an eine obere Oberfläche einer leitfähigen Trägerplatte (230), die aus einem starren Material hergestellt ist, gebildet ist, und
ein Material der feinen Partikel oder der Feinfasernetzwerke, die mit dem oberen Anschluss (100) und dem unteren Anschluss beschichtet oder gebunden sind, mindestens eines von Übergangsmetall, Aluminium, Kohlenstoff und leitfähigem Polymer umfasst.

4. Elektrodenwiderstandsmessvorrichtung nach Anspruch 1, wobei ein Material der leitfähigen Druckplatte (130) und der leitfähigen Trägerplatte (230) mindestens eines von Übergangsmetall auf einem Periodensystem, Aluminium und Kohlenstoff umfasst.

5. Elektrodenwiderstandsmessvorrichtung nach Anspruch 1, wobei die leitfähige Paste (120, 220) durch Mischen leitfähiger Partikel, Bindemittel und Lösungsmittel in einem Pastenzustand erhalten wird,
ein Material der leitfähigen Partikel der leitfähigen Paste (120, 220) mindestens eines von Ruß, Graphit, CNT, Graphen, Übergangsmetall und Aluminium umfasst, und
eine Größe der leitfähigen Partikel der leitfähigen Paste (120, 220) D₅₀ von 20 µm oder weniger ist.

6. Elektrodenwiderstandsmessvorrichtung nach Anspruch 5, wobei die leitfähige Paste (120, 220) auf eine Dicke von 20 µ m bis 200 µm zwischen der ersten Gasdiffusionsschicht und der leitfähigen Druckplatte (130) und zwischen der zweiten Gasdiffusionsschicht und der leitfähigen Trägerplatte (230) gebildet ist.

7. Elektrodenwiderstandsmessvorrichtung nach Anspruch 1, wobei eine Porosität der mikroporösen Schicht (111, 211) der ersten Gasdiffusionsschicht und der mikroporösen Schicht (111, 211) der zweiten Gasdiffusionsschicht 30 % bis 80 % ist.

8. Elektrodenwiderstandsmessvorrichtung nach Anspruch 1, wobei eine Dicke der mikroporösen Schicht (111, 211) der ersten Gasdiffusionsschicht und der mikroporösen Schicht (111, 211) der zweiten Gasdiffusionsschicht 20 µm bis 150 µm ist.

9. Elektrodenwiderstandsmessvorrichtung nach Anspruch 3, wobei ein Lastkörper (140) zum Pressen der Messzielelektrode (11) auf einer oberen Oberfläche des oberen Anschlusses (100) gestapelt ist.

10. Elektrodenwiderstandsmessvorrichtung nach Anspruch 9, wobei jeder von dem oberen Anschluss (100) und dem Lastkörper (140) in einer Scheibenform bereitgestellt ist.

## Revendications

1. Appareil de mesure de résistance d'électrode comprenant :
une borne supérieure (100) dont la surface de fond est configurée pour être couplée à une surface supérieure d'une électrode de mesure cible (11) ;
une borne inférieure (200) dont la surface supérieure est configurée pour être couplée à une surface inférieure de l'électrode de mesure cible (11) ; et
une unité de mesure de résistance (300) connectée électriquement à la borne supérieure (100) et à la borne inférieure pour mesurer une résistance de l'électrode de mesure cible (11),
dans lequel des couches microporeuses (111, 211) sont formées sur la surface de fond de la borne supérieure (100) et de la surface supérieure de la borne inférieure (200), respectivement, les couches microporeuses (111, 211) sont configurées pour être en contact direct avec l'électrode de mesure cible (11),
dans lequel la borne supérieure (100) comprend :
une plaque de pression conductrice (130) faite d'un matériau conducteur et ayant une surface de fond formée en un plan perpendiculaire à une direction verticale ; et
une première couche de diffusion de gaz (110) fixée à la surface de fond de la plaque de pression conductrice (130), et dans lequel
la borne inférieure comprend :
une plaque de support conductrice (230) faite d'un matériau conducteur et ayant une surface supérieure formée en un plan perpendiculaire à la direction verticale ; et
une deuxième couche de diffusion de gaz (210) fixée à la surface supérieure de la plaque de support conductrice (230) ;
dans lequel la première couche de diffusion de gaz (110) et la deuxième couche de diffusion de gaz (210) comprennent chacune la couche microporeuse (111, 211) et une couche de fibres de carbone (112, 212) ;
dans lequel une surface supérieure de la couche de fibres de carbone (112) de la première couche de diffusion de gaz (110) est adhérée à la surface de fond de la plaque de pression conductrice (130),
la couche microporeuse (111) est empilée sur une surface de fond de la couche de fibres de carbone (112) dans la première couche de diffusion de gaz (110),
une surface de fond de la couche de fibres de carbone (212) de la deuxième couche de diffusion de gaz (210) est adhérée à la surface supérieure de la plaque de support conductrice (230), et
la couche microporeuse (211) est empilée sur une surface supérieure de la couche de fibres de carbone (212) dans la deuxième couche de diffusion de gaz (210), et
dans lequel une pâte conductrice (120, 220) fixe la surface supérieure de la couche de fibres de carbone (112) de la première couche de diffusion de gaz (110) à la surface de fond de la plaque de pression conductrice (130) et la surface de fond de la couche de fibres de carbone (212) de la deuxième couche de diffusion de gaz (210) à la surface supérieure de la plaque de support conductrice (230).

2. Appareil de mesure de résistance d'électrode selon la revendication 1, dans lequel un matériau des couches microporeuses (111, 211) comprend au moins un élément parmi du carbone, un métal conducteur et un polymère conducteur.

3. Appareil de mesure de résistance d'électrode selon la revendication 1, dans lequel la couche microporeuse (111, 211) de la borne supérieure (100) est formée en revêtant ou en liant des particules fines ayant un D₅₀ de 5 µm ou moins ou un réseau de fibres fines ayant une largeur de 10 µm ou moins à une surface de fond d'une plaque de pression conductrice (130) faite d'un matériau rigide,
la couche microporeuse (111, 211) de la borne inférieure est aussi formée en revêtant ou en liant des particules fines ayant un D₅₀ de 5 µm ou moins ou un réseau de fibres fines ayant une largeur de 10 µm ou moins à une surface supérieure d'une plaque de support conductrice (230) faite d'un matériau rigide, et
un matériau des particules fines ou les réseaux de fibres fines revêtus ou liés à la borne supérieure (100) et à la borne inférieure comprennent au moins un élément parmi un métal de transition, de l'aluminium, du carbone et un polymère conducteur.

4. Appareil de mesure de résistance d'électrode selon la revendication 1, dans lequel un matériau de la plaque de pression conductrice (130) et de la plaque de support conductrice (230) comprend au moins un élément parmi un métal de transition sur un tableau périodique, de l'aluminium et du carbone.

5. Appareil de mesure de résistance d'électrode selon la revendication 1, dans lequel la pâte conductrice (120, 220) est obtenue en mélangeant des particules conductrices, un liant et un solvant dans un état de pâte,
un matériau des particules conductrices de la pâte conductrice (120, 220) comprend au moins un élément parmi du noir de carbone, du graphite, CNT, du graphène, un métal de transition et de l'aluminium, et
une taille des particules conductrices de la pâte conductrice (120, 220) est D₅₀ de 20 µm ou moins.

6. Appareil de mesure de résistance d'électrode selon la revendication 5, dans lequel la pâte conductrice (120, 220) est formée en une épaisseur de 20 µm à 200 µm entre la première couche de diffusion de gaz et la plaque de pression conductrice (130) et entre la deuxième couche de diffusion de gaz et la plaque de support conductrice (230).

7. Appareil de mesure de résistance d'électrode selon la revendication 1, dans lequel une porosité de la couche microporeuse (111, 211) de la première couche de diffusion de gaz et de la couche microporeuse (111, 211) de la deuxième couche de diffusion de gaz est 30 % à 80 %.

8. Appareil de mesure de résistance d'électrode selon la revendication 1, dans lequel une épaisseur de la couche microporeuse (111, 211) de la première couche de diffusion de gaz et de la couche microporeuse (111, 211) de la deuxième couche de diffusion de gaz est 20 µm à 150 µm.

9. Appareil de mesure de résistance d'électrode selon la revendication 3, dans lequel un corps de charge (140) pour presser l'électrode de mesure cible (11) est empilé sur une surface supérieure de la borne supérieure (100).

10. Appareil de mesure de résistance d'électrode selon la revendication 9, dans lequel la borne supérieure (100) et le corps de charge (140) sont fournis sous une forme de disque.
